Europäisches Patentamt

European Patent Office

Office européen des brevets

(11) Veröffentlichungsnummer: **0 183 138**
**A1**

## EUROPÄISCHE PATENTANMELDUNG

(21) Anmeldenummer: 85114452.7

(22) Anmeldetag: 13.11.85

(51) Int. Cl.4 **H01L 21/28** , H01L 21/00 , H01L 21/74 , H01L 21/76 , H01L 21/82

(30) Priorität: 29.11.84 DE 3443580

(43) Veröffentlichungstag der Anmeldung:
04.06.86 Patentblatt 86/23

(84) Benannte Vertragsstaaten:
AT DE FR GB IT NL

(71) Anmelder: **Siemens Aktiengesellschaft**
**Berlin und München Wittelsbacherplatz 2**
**D-8000 München 2(DE)**

(72) Erfinder: **Beinvogl, Willy, Dr.**
**Mallnitzer Strasse 16**
**D-8000 München 21(DE)**
Erfinder: **Enders, Gerhard, Dipl.-Phys.**
**Stüdlstrasse 5**
**D-8000 München 50(DE)**
Erfinder: **Mohr, Ernst-Günter, Dipl.-Phys.**
**Erich-Kästner-Strasse 10**
**D-8000 München 40(DE)**

(54) Verfahren zum Herstellen von Hochintegrierten MOS-Transistorschaltungen.

(57) Bei einem Verfahren zum Herstellen von hochintegrierten MOS-Transistorschaltungen werden zugleich Transistoren mit Abstandsschichttechnik ("spacer"-Technik) und ohmschen Kontakten von der Gatemetallisierung zu den diffundierten Bereichen im Substrat (sogenannte buried contacts) dadurch erzeugt, daß die Kontaktlöcher (B) an der gewünschten Stelle des Substrats (1) vor der ganzflächigen Abscheidung der Abstandsschicht (9, 10) geöffnet werden, die Abstandsschicht (9, 10) an den Flanken der Gates und an den Flanken der als Zuleitung dienenden Gatemetallisierung (5) gleichzeitig strukturiert wird und der Kontaktlochbereich (B) zugleich mit der Source/Drain-Ionenimplantation (13) dotiert wird. Durch die kombinierte Realisierung der Herstellung von Transistoren in spacer-Technik (LDD-Transistoren) und buried-Kontakten ist die Möglichkeit gegeben, MOS-Logik- und Speicher-Schaltungen mit spannungsfesten Transistoren in hoher Packungsdichte herzustellen.

Verfahren zum Herstellen von hochintegrierten MOS-Transistorschaltungen.

Die Erfindung betrifft ein Verfahren zum Herstellen von hochintegrierten MOS-Transistorschaltungen, bei dem die Herstellung der Source/Drain-Bereiche der n- bzw. p-Kanal-Transistoren durch Ionenimplantation unter Verwendung des Gate als Implantationsmaske vorgenommen wird und die Source/Drain-Ionenimplantation durch eine an den Gateflanken zusätzlich erzeugte Abstandsschicht (sogenannter spacer) abgeschirmt wird, und bei dem zugleich ohmsche Kontakte zwischen der als Zuleitung dienenden Gatemetallisierung und den diffundierten Bereichen im Halbleitersubstrat (sogenannte "buried contacts") erzeugt werden.

Im Zuge der Entwicklung zu immer feineren Strukturabmessungen der Transistoren in MOS-Logik- und Speicher-Schaltungen gewinnen deren Spannungsfestigkeit und die Verringerung parasitärer Effekte, wie zum Beispiel Überlappkapazitäten (Gate zu Source/Drain-Gebieten) zunehmend an Bedeutung. Eine Methode zur Lösung dieses Problems ist der sogenannte LDD ( = lightly doped drain)-Transistor, wie er beispielsweise in einem Aufsatz von P. I. Tsang et al im IEEE Trans. El. Dev. ED 29 (1982) auf den Seiten 590 bis 596 beschrieben wird. LDD-Transistoren werden bekannterweise mit einer sogenannten spacer-Technik hergestellt. Das bevorzugte spacer-Material ist $SiO_2$, da es sich konform über Stufen abscheiden läßt, elektrisch isoliert und sich sehr maßhaltig ätzen läßt. In dem Aufsatz von Tsang wird über eine Oxidschicht an den Flanken des Transistorgate ein Abstand zwischen Gate und Kanten der Source/Drain-Ionenimplantation (Source/Drain-pull back mittels side wall spacer) durch eine zusätzlich abgeschiedene spacer Oxidschicht eingestellt, die vor der Source/Drain-Ionenimplantation anisotrop geätzt wird.

Ein weiteres Verfahren, bei dem die sidewall-spacer-Technik angewandt wird, ist aus einem Aufsatz von I. Miyomoto et al aus dem IEDM 83, Seiten 63 bis 66 zu entnehmen. Dabei wird zur Herstellung von CMOS-Bipolartransistorschaltungen eine spacer-Technik mit einer Doppelschicht aus Polysilizium und $SiO_2$ verwendet. Diese hat vor allem den Vorteil, daß bei der Rückätzung eine Endpunkterkennung zu dem darunterliegenden $SiO_2$ möglich ist, so daß sowohl auf Feldgebieten wie auf späteren Diffusionsgebieten der Angriff auf $SiO_2$ minimal ist und keine Schädigung des einkristallinen Substrats erfolgt. Da zum Unterschied zu $SiO_2$ an dieser Stelle eine Rückätzung schwieriger ist, weil eine maßhaltige Abbildung der Polysiliziumdicke entlang der Stufen in chlorhaltigen Plasmen vermutlich wegen der körnigen Struktur der Schicht nur schwerzu realisieren ist, wird eine dünne, zum Beispiel aus $SiO_2$ bestehende Hilfsschicht benutzt und die spacer-Strukturierung durch Ätzung der Doppelschicht vorgenommen.

Die Aufgabe, die der Erfindung zugrundeliegt, besteht in der Durchführung eines MOS-Prozesses der eingangs genannten Art, bei dem der bei vielen Logik- und Speicherschaltungen benötigte ohmsche Kontakt zwischen der Gatemetallisierung und den Diffusionsgebieten im Siliziumsubstrat (buried contacts) gleichzeitig mit den LDD-Transistoren in spacer-Technik mithergestellt wird. Dabei soll dieser Kontakt sehr niederohmig und platzsparend und die entstehende Topographie möglichst eben sein.

Üblicherweise wird ein "buried contact" durch Öffnen eines Kontaktloches vor der Abscheidung der Gatemetallisierungsschicht hergestellt. Das Kontaktloch selbst kann entweder vor der Schichtabscheidung oder danach durch Ausdiffusion des Dotierstoffes zum Beispiel aus dem Polysilizium dotiert werden. Nähere Einzelheiten über buried contacts sind aus der US-PS 3.699.646 und aus dem IBM Techn. Discl. Bull. Vol. 24, Nr. 6, November 1981, auf den Seiten 2863 bis 2866, zu entnehmen.

Die Erfindung löst die gestellte Aufgabe der gleichzeitigen Herstellung von Transistoren in spacer-Technik und buried contacts in einer integrierten MOS-Schaltung dadurch, daß vor der ganzflächigen Abscheidung der Abstandsschicht die Kontaktlöcher an der gewünschten Stelle des Substrats geöffnet werden und daß mit der Strukturierung der Abstandsschicht an den Flanken des Gates auch eine Abstandsschicht an den Flanken der Gatemetallisierung strukturiert wird, so daß bei der nachfolgenden Erzeugung der Source/Drain-Bereiche auch die Kontaktlochbereiche im Halbleitersubstrat und in der Abstandsschicht dotiert werden. Dabei liegt es im Rahmen der Erfindung, daß die Abstandsschicht aus einer Doppelschicht besteht, wobei neben $SiO_2$ als Oberflächenschicht Polysilizium, ein Silizid hochschmelzender Metalle oder ein hochschmelzendes Metall verwendet wird. Die obere Schicht dieser Doppelschicht, zum Beispiel $SiO_2$ oder auch $Si_3N_4$ übt nur eine Hilfsfunktion aus, nämlich die, die exakt maßhaltige Erzeugung der leitfähigen Abstandsschicht zu ermöglichen. Die darunterliegende leitfähige Schicht, die in Bereichen des "buried contact" die Verbindung zwischen Gate und Substrat darstellt, kann aus Polysilizium oder einem Metallsilizid bestehen. Die Gatemetallisierung selbst kann aus dotiertem Polysilizium, einem hochschmelzenden Metall, einem Silizid oder auch einer Doppelschicht Polysilizium/Silizid bestehen. Die Kombination Gatemetallisierung-Abstandsschicht ist so zu wählen, daß ein ohmscher Kontakt entsteht. Es ist ein Vorteil der Erfindung, daß die Dotierung der Abstandsschicht gleichzeitig mit der Source/Drain-Implantation erfolgen kann.

Weitere Ausgestaltungen der Erfindung, insbesondere Prozeßfolgen zur Herstellung von n-MOS- oder CMOS-Schaltungen sind in den Unteransprüchen enthalten.

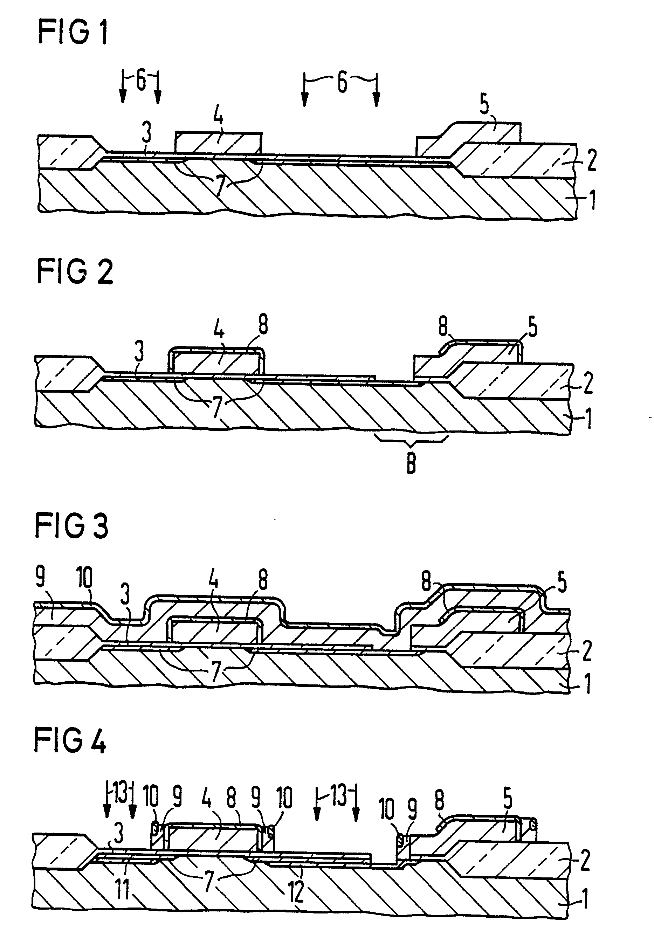

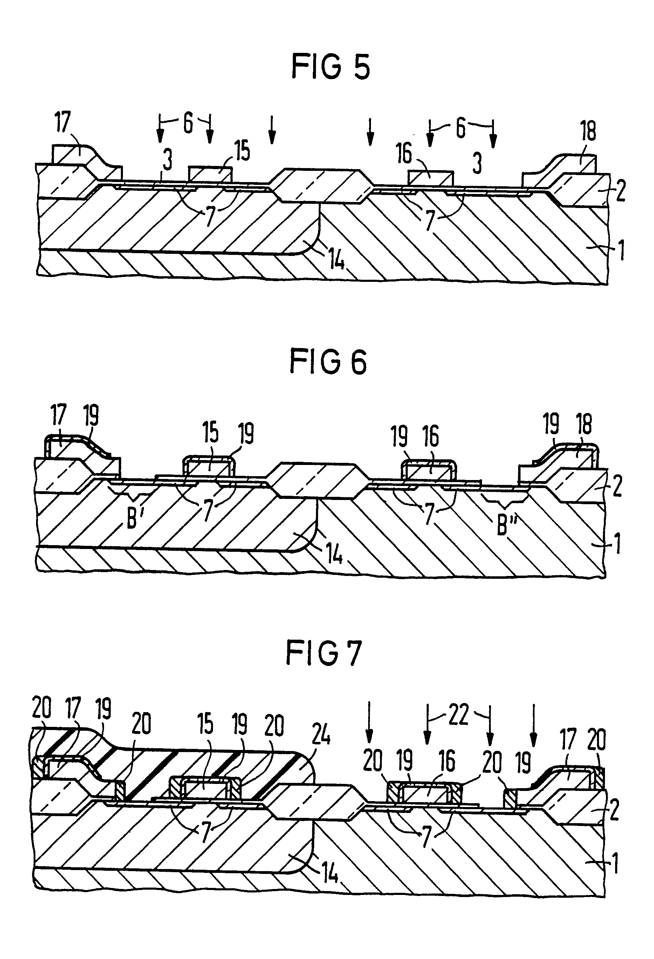

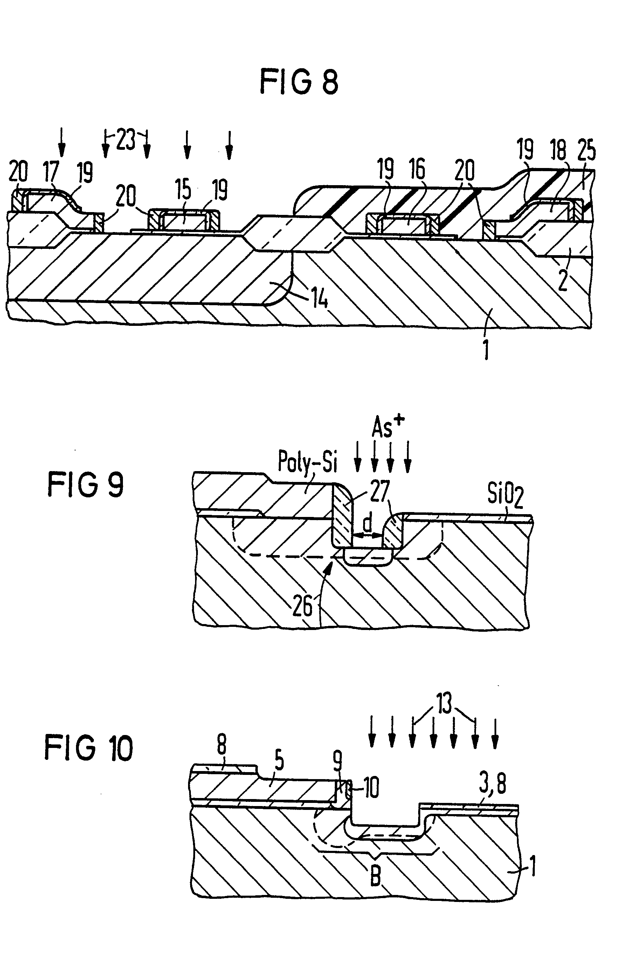

Nähere Einzelheiten werden nachfolgend anhand von zwei Ausführungsbeispielen und der Figuren 1 bis 10, welche im Schnittbild die erfindungswesentlichen Verfahrensschritte darstellen, beschrieben. Anhand der Figuren 1 bis 4 wird der Prozeßablauf zur Herstellung von n-Kanal-MOS-Transistoren in spacer-Technik mit buried contacts in einem n-MOS-Prozeß beschrieben. Wie aus den Figuren 5 bis 8 zu entnehmen ist, ist das erfindungsgemäße Verfahren aber auch auf CMOS-Prozesse anwendbar. Die Figuren 9 und 10 zeigen im Detail einen herkömmlichen buried-contact (Figur 9) mit anschließender spacer-Technik (oxide spacer mit LDD-Transistoren) und einen Polysilizium-spacer mit buried contact nach dem erfindungsgemäßen Verfahren (Figur 10). In allen Figuren gelten für gleiche Teile gleiche Bezugzeichen.

Die Prozeßschritte bis zur Strukturierung des aus zum Beispiel Polysilizium bestehenden Gates entsprechen bekannten Prozeßabläufen, ebenso die Fertigstellung der Schaltung nach dem Erzeugen der Source/Drain-Bereiche. Auf diese Verfahrenschritte wird hier nicht eingegangen.

Figur 1: In einem aus p-dotiertem Silizium bestehenden Substrat 1, in welchem die aktiven Transistorzonen durch Feldoxidbereiche 2 getrennt sind und auf welchen das Gateoxid 3 mit einer Schichtdicke von ungefähr 20 nm erzeugt ist, wird nach gleichzeitiger Strukturierung der aus Polysilizium bestehenden Gateelektrode 4 und der als Zuführung dienenden Gatemetallisierung 5 eine Implantation mit zum Beispiel Phosphor-Ionen (siehe Pfeile 6) mit einer Dosis und Energie von 5 x 10^12 cm^-2 und 80 keV zur Herstellung einer flachen Anschlußdiffusionszone 7 durchgeführt.

Figur 2: Dann werden die Gatebereiche 4 und 5 mit einer isolierenden Schicht 8 zum Beispiel aus durch thermische Oxidation erzeugtem SiO_2 umgeben und anschließend mit einem Fotolithographie/Ätzschritt Bereiche B freigelegt, in denen ein buried-contact gebildet werden soll.

Figur 3: Es erfolgt nun die ganzflächige Abscheidung der als spacer wirkenden Doppelschicht 9, 10, wobei die aus zum Beispiel Polysilizium bestehende Schicht 9 entsprechend der Gatemetallisierung 5 dotiert ist oder wird. Die aus SiO_2 bestehende Schicht 10 dient als Hilfsschicht und kann später wieder entfernt werden.

Figur 4: Nach erfolgter spacer-Strukturierung, welche die Ätzung der Doppelschicht 9, 10 beinhaltet, werden die Source/Drain-Zonen 11, 12 durch eine zum Beispiel Arsenionen (siehe Pfeile 13) enthaltende Implantation bei einer Dosis und Energie von zum Beispiel 6 x 10^15 cm^-2 und 100 keV erzeugt.

Durch die nachfolgende Ausheilung der Ionenimplantation 13 entstehen neben den Source/Drain-Bereichen 11 und 12 der diffundierte buried contact. Näheres siehe Figuren 9 und 10.

Die Ätzfolge bei der Erzeugung des Polysilizium/SiO_2-spacers geschieht durch reaktives Ionenätzen in zwei Schritten:

a) für die SiO_2 Schicht 10 in Trifluormethan und Sauerstoff bei 7 Pa (50 mTorr) und einer Ätzrate von 50 nm/min und

b) für die Polysiliziumschicht 9 in einer chlorhaltigen Atmosphäre, zum Beispiel in einem Gemisch aus Chlor und Bortrichlorid.

Analog wie bei den Figuren 1 bis 4 beschrieben, kann die Prozeßfolge auch an die CMOS-Technologie angepaßt werden. Hier ist das erfindungsgemäße Verfahren besonders vorteilhaft, weil sehr viele Varianten möglich sind, abhängig davon, ob nur der n-Kanal-Transistor als LDD-Transistor ausgebildet werden soll oder sowohl n- als auch p-Kanal-Transistor. Eine weitere Variante liegt im Gatematerial, wo sowohl das hauptsächlich übliche n^+-Polysilizium oder ein Polizid oder ein Silizid, als auch hochschmelzende Metalle verwendet werden können.

Im folgenden wird ein CMOS-Prozeß mit einer n-Wanne beschrieben. Dabei wird nur der n-Kanal-Transistor als LDD-Transistor ausgebildet.

Figur 5: Nach der n-Wannenerzeugung 14 im p-dotierten Substrat 1 und nach der Definition der aktiven Transistorzonen durch Feldoxidbereiche 2 wird die Gateoxidation wie bei Figur 1 beschrieben durchgeführt. Dann werden gleichzeitig die Gates 15 und 16 und die als Zuführung dienende Gatemetallisierung 17 und 18 strukturiert. Die Implantation mit Arsen oder Phosphor-Ionen zur Herstellung einer flachen Anschlußdiffusionszone 7 erfolgt wie bei Figur 1 beschrieben (siehe Pfeile 6).

Figur 6: Nach der n^--Anschlußimplantation (6, 7) erfolgt das Umgeben der Gatemetallisierung 15, 16, 17, 18 mit einer isolierenden Schicht 19, zum Beispiel SiO_2, wie bei Figur 2 beschrieben und das Öffnen der Kontaktlochbereiche B' und B'' für die buried contacts.

Figur 7: Analog wie bei Figur 3 beschrieben, wird die spacer-Schichtstruktur 20, bestehend aus zum Beispiel durch CVD-Abscheidung erzeugtes Tantaldisilizid (TaSi_2) hergestellt.

Die anisotrope Ätzung von Tantalsilizid ist in verschiedenen Chemismen möglich. Zum Beispiel kann ein reaktives Ionenätzen in SF_6 im Druckbereich von einigen Pascal erfolgen. Oder die Ätzung kann in einem ähnlichen Druckbereich in einer Mischung aus Bortrichlorid und Chlor (BCl_3 und Cl_2) erfolgen, wobei die Bedeutung einer BCl_3-Zugabe vor allem darin liegt, Oberflächenfilme zu beseitigen, die sonst einen gleichmäßigen Ätzangriff des Silizids verhindern. Wenn als elektrisch leitfähige Abstandsschicht eine Silizidschicht benutzt wird, ist die richtige Prozeßschrittfolge zu beachten. Im allgemeinen ist nach der Abscheidung (durch Verdampfung, Sputtern oder in einem CVD-Prozeß) die Schichtzusammensetzung nicht exakt stöchiömetrisch (das heißt zum Beispiel 33.3 % Ta im Falle von TaSi_2). Um Materialwanderungseffekte im Bereich der "buried contacts" zu vermeiden, soll die Silizidbildung durch einen entsprechenden Hochtemperaturschritt nach der Erzeugung der Abstandsschicht erfolgen.

Die Source/Drain-Ionenimplantationen 22 und 23 mit Arsen-Ionen und Bor-Ionen wird durchgeführt, wobei die jeweiligen Bereiche mit Fotolack-Maskierungen 24, 25 abgedeckt werden. In Figur 7 wird gerade die Arsen Ionen-Implantation 22 durchgeführt, wobei der n-Wannenbereich 14 mit der Fotolackmaske 24 abgedeckt ist. Es entstehen die n^+-dotierten Gebiete als Source/Drain-Anschlüsse. Sie sind der besseren Übersicht wegen nicht eingezeichnet.

Figur 8: Hier wird die Source/Drain-Ionenimplantation 23 mit Bor durchgeführt, wobei die Fotolackmaske 25 die bereits mit einer hohen As-Dosis (22) implantierten Bereiche vor Kompensation schützt. Es entstehen in der n-Wanne 14 p^+-dotierte Gebiete als Source/Drain-Anschlüsse. Sie sind der besseren Übersicht wegen nicht eingezeichnet.

Während der Source/Drain-Ionenimplantationen 22, 23 werden die jeweils freiliegenden spacer mitdotiert. Durch einen Hochtemperaturschritt im Bereich von 900 °C wird dieser Dotierstoff in Bereichen B' und B'' der buried contacts in das Substrat 1 ausgetrieben und stellt mit dem Diffusionsgebiet einen ohmschen Kontakt her. Dieser Hochtemperaturschritt kann gleichzeitig mit der Aktivierung der Hochdosisimplantationen 22 und 23 ausgeführt werden.

Ein Vergleich der Figuren 9 und 10 zeigt deutlich den Unterschied zwischen einem buried contact, der nach dem Verfahren nach der Lehre der Erfindung hergestellt worden ist (Figur 10) und einem herkömmlichen buried contact mit anschließender spacer-Technik (Figur 9). Während bei dem herkömmlichen buried contact, wie der Pfeil 26 zeigt, der Überlapp kritisch ist, weil der Abstand d der aus SiO_2 bestehenden Flankenisolation 27 von Justiertoleranzen abhängt, liegt dieses Problem bei der erfindungsgemäßen Anordnung nicht vor. Die strichlierten Linien zeigen die Front des aus dem Polysilizium (Figur 9) bzw. aus dem spacer ausdiffundierten Dotierstoffes. Die durchgezogene Linie zeigt den Verlauf der durch die Arsenionenimplantation und anschließender Diffusion erzeugten Gebiete im Siliziumsubstrat 1 (bzw. in der n-Wanne 14).

Gegebenenfalls können die leitfähigen Abstandsschichten nach erfolgten Implantationen unter Verwendung einer Maske, die die buried contact-Bereiche abdeckt, wieder entfernt werden.

Durch das Verfahren nach der Lehre der Erfindung werden folgende Vorteile gegenüber bekannnten Prozeßtechniken erreicht:

1. Der buried contact kann vor der Abscheidung der spacer-Schicht geätzt werden.

2. Die Gateoxidbereiche unter den Gates sind bei der Foto-Ätztechnik für den buried contact geschützt, da der

buried contact nach der Herstellung der Gatemetallisierung geöffnet wird.

3. Die spacer-Ätzung kann auf Dick- und Dünnoxidbereichen selektiv geführt werden, denn Polysilizium kann hochselektiv zu $SiO_2$ geätzt werden; beim spacer aus $SiO_2$ dagegen gibt es keinen Ätzstop.

4. Zur Erreichung geringer Dotierstoffeindringtiefen im buried contact kann das Polysilizium mit Arsen dotiert werden. In der üblichen Version des buried contact ist dies problematisch, da Arsen durch dünne $SiO_2$-Schichten diffundiert.

5. Die Anätzung des Substrats im buried contact kann minimiert werden, da eine Endpunkterkennung möglich ist und nicht überätzt wird. Das sehr schwierige Ätzproblem, welches in einem Doppel-Polysilizium-Gate-Prozeß bei der Strukturierung der zweiten Polysiliziumebene im Falle eines buried contact gegeben ist, wird dadurch auf zwei Prozeßschritte verteilt.

6. Der Anschluß der Diffusionsgebiete im buried contact ist unkritischer als im Falle eines $SiO_2$-spacers (Figur 9), da hier der spacer selbst als Dotierstoffquelle dient (Figur 10) und im angeätzten Bereich keine Abschattung der Source/Drain-Ionenimplantation erfolgt (Figur 10).

7. Die Dicke der isolierenden Schicht zwischen dem Polysilizium-spacer und der Gatemetallisierung bestimmt wesentlich die entsprechenden parasitären Kapazitäten.

Ein weiterer Vorteil liegt darin, daß, wenn das Gatematerial ebenfalls aus einem Silizid oder Polizid besteht, eine direkte ohmsche Verbindung zwischen $n^+$- und $p^+$-Gebieten hergestellt werden kann. Eine solche Verdrahtungsmöglichkeit ist zum Beispiel für statische RAMs (6-Transistorzelle) sehr platzsparend.

**Ansprüche**

1. Verfahren zum Herstellen von hochintegrierten MOS-Transistorschaltungen, bei dem die Herstellung der Source/Drain-Bereiche der n- bzw. p-Kanal-Transistoren durch Ionenimplantation unter Verwendung des Gate als Implantationsmaske vorgenommen wird und die Source/Drain-Ionenimplantation durch eine an den Gateflanken zusätzlich erzeugte Abstandsschicht (sogenannter spacer) abgeschirmt wird, und bei dem zugleich ohmsche Kontakte zwischen der als Zuleitung dienenden Gatemetallisierung und den diffundierten Bereichen im Halbleitersubstrat (sogenannte buried Kontakte) erzeugt werden, **dadurch gekennzeichnet**, daß vor der ganzflächigen Abscheidung der Abstandsschicht (9, 10, 20) die Kontaktlöcher (B, B', B'') an der gewünschten Stelle des Substrats (1, 14) geöffnet werden und daß mit der Strukturierung der Abstandsschicht (9, 10, 20) an den Flanken der Gates (4, 15, 16) auch eine Abstandsschicht an den Flanken der Gatemetallisierung (5, 17, 18) strukturiert wird, so daß bei der nachfolgenden Erzeugung der Source/Drain-Bereiche (11, 12) auch die Kontaktlochbereiche (B, B', B'') im Halbleitersubstrat (1, 14) und in der Abstandsschicht dotiert werden.

2. Verfahren nach Anspruch 1, **dadurch gekennzeichnet**, daß die Abstandsschicht aus einer Doppelschicht (9, 10) besteht, wobei neben $SiO_2$ als Oberflächenschicht (10)

Polysilizium, ein Silizid hochschmelzender Metalle besteht oder ein hochschmelzendes Metall verwendet wird.

3. Verfahren nach Anspruch 1, **dadurch gekennzeichnet**, daß die Abstandsschicht (20) aus einem Silizid hochschmelzender Metalle, wie Tantalsilizid, oder aus einem hochschmelzenden Metall besteht.

4. Verfahren nach mindestens einem der Ansprüche 1 bis 3, **dadurch gekennzeichnet**, daß ein der Gatemetallisierung angepaßter Dotierstoff bei oder nach der Abscheidung in die Abstandsschicht (9, 20) eingebracht wird.

5. Verfahren nach mindestens einem der Ansprüche 1 bis 4, **dadurch gekennzeichnet**, daß die aus $SiO_2$ bestehende Oberflächenschicht (10) auf der Abstandsschicht (9) nach der Strukturierung wieder entfernt wird.

6. Verfahren im Rahmen eines nMOS-Prozesses zum Herstellen eines MOS-Transistors vom n-Kanal-Typ mit abgeschirmter Source/Drain-Ionenimplantation und ohmschen Kontakt zum Substrat nach mindestens einem der Ansprüche 1 bis 5, **gekennzeichnet durch** den Ablauf der folgenden Verfahrensschritte:

a) Definition der aktiven Transistorbereiche durch Erzeugen von Feldoxidbereichen (2) in dem Halbleitersubstrat (1) zum Beispiel durch die sogenannte LOCOS-Technik,

b) Erzeugen des Gateoxids (3),

c) Durchführung der Gatemetallisierung mit gleichzeitiger Strukturierung des Gate (4) und der Zuleitung (5) zum Substratkontakt (1),

d) Durchführung einer $n^-$-Ionenimplantation (6) zur Herstellung einer flachen Anschlußdiffusionszone (7),

e) Erzeugung einer Isolationsschicht (8) auf dem Gatematerial (4, 5) durch Abscheidung zum Beispiel einer $SiO_2$-Schicht (8) oder durch thermische Oxidation von zum Beispiel Polysilizium (4, 5),

f) Öffnen des gewünschten Kontaktloches (B) durch Entfernen der nach Verfahrensschritt e) aufgebrachten Oxidschicht (8) und des Gateoxids (3) an dieser Stelle nach erfolgter Fotolithographie,

g) Abscheidung der als Abstandsschicht wirkenden, aus vorzugsweise Polysilizium (9) mit einer Oberflächenschicht (10) aus $SiO_2$ bestehenden Doppelschicht (9, 10),

h) Strukturierung der Doppelschicht (spacer) so, daß die Gateflanken (4) und die Flanken der aus der Gatemetallisierung (5) bestehenden Zuleitung mit dieser Doppelschicht (9, 10) bedeckt bleiben,

i) Durchführung der $n^+$-Ionenimplantation (13) zur Erzeugung der Source/Drain-Bereiche (11, 12) und des diffundierten Substratbereiches im Kontaktloch (B).

7. Verfahren nach Anspruch 6, **dadurch gekennzeichnet**, daß die Strukturierung der Doppelschicht (9, 10) zur Erzeugung der Abstandsschicht (spacer) in zwei Schritten durch reaktives Ionenätzen erfolgt:

a) für die SiO₂-Schicht (10) in Trifluormethan und Sauerstoff und

b) für die Polysiliziumschicht (9) in einer chlorhaltigen Atmosphäre bestehend zum Beispiel aus einem Gemisch aus Chlor und Bortrichlorid.

8. Verfahren zum Herstellen einer sowohl n- als auch p-Kanal-Transistoren enthaltenden integrierten Schaltung (CMOS) nach mindestens einem der Ansprüche 1 bis 7, **gekennzeichnet durch** den Ablauf der folgenden Verfahrensschritte:

a) Erzeugen der n-Wanne (14) im p-dotierten Substrat (1) durch Ionenimplantation und anschließender Diffusion von Phosphorionen nach Maskierung der übrigen Substratoberfläche (p-Gebiet),

b) Definition der aktiven Transistorbereiche durch Erzeugen von Feldoxidbereichen (2) zum Beispiel durch die sogenannten LOCOS-Technik nach vorheriger Entfernung der Maskierung von Verfahrensschritt a),

c) Erzeugen der Gateoxidschicht (3),

d) Durchführung der Gatemetallisierung mit Strukturierung der Gates (15, 16) und der Zuleitungen (17, 18) zum Substrat (1, 14),

e) Durchführung einer n⁻-Ionen-Implantation (6) vorzugsweise mit Phosphorionen zur Herstellung einer flachen Anschlußdiffusionszone (7) in der n-Wanne (14),

f) Erzeugung einer Oxidschicht (19) auf den Gates (15, 16, 17, 18) durch Abscheidung von SiO₂ (19) oder durch thermische Oxidation von zum Beispiel Polysilizium (15, 16, 17, 18),

g) Öffnen der gewünschten Kontaktlöcher (B', B'') durch Entfernen der nach Verfahrensschritt f) aufgebrachten Oxidschicht (19) und des Gateoxids (3) an dieser Stelle nach erfolgter Fotolithographie,

h) Abscheidung der als Abstandsschicht (20) wirkenden Schicht und Strukturierung dieser Schicht (spacer) so, daß die Gateflanken (15, 16) und die Flanken der aus der Gatemetallisierung bestehenden Zuleitungen (17, 18) mit dieser Schicht (20) bedeckt bleiben,

i) Durchführung der n⁺- bzw. p⁺-Ionenimplantation (22, 23) im p-Bereich des Substrats (1) bzw. in der n-Wanne (14) nach vorheriger jeweiliger Fotolack-Maskierung (24, 25) der n-Wanne (14) bzw. des p-dotierten Substratbereiches (1) zur Erzeugung der Source/Drain-Bereiche und des diffundierten Substratbereiches im Kontaktloch (B', B'') der n-Kanal-bzw. p-Kanal-Transistoren und

j) Durchführung einer Hochtemperaturbehandlung zum Eintreiben der implantierten Dotierstoffionen.

9. Verfahren nach Anspruch 8, **dadurch gekennzeichnet**, daß als Abstandsschicht (20) nach Verfahrensschritt h) Tantaldisilizid verwendet wird, welches durch Abscheiden aus der Gasphase (CVD = chemical vapor deposition) erzeugt wird.

10. Verfahren nach Anspruch 9, **dadurch gekennzeichnet**, daß die Strukturierung durch reaktives Ionenätzen in Schwefelhexafluorid (SF₄) oder in einer Mischung aus Bortrichlorid und Chlor in einem Druckbereich von 5 - 10 Pa durchgeführt wird.

11. Verwendung des Verfahrens nach mindestens einem der Ansprüche 8 bis 10 zur Herstellung von statischen Schreib-/Lesespeicher (RAM) (6-Transistor-Zelle), wobei sowohl für die Gatemetallisierung als auch für die Abstandsschicht Metallsilizide oder die Kombination Polysilizium/Metallsilizid verwendet werden.

0 183 138

**FIG 1**

**FIG 2**

**FIG 3**

**FIG 4**

FIG 5

FIG 6

FIG 7

# FIG 8

# FIG 9

As$^+$

Poly-Si

SiO2

27

d

26

# FIG 10

13

8    5    9    10    3,8

B    1

## EINSCHLÄGIGE DOKUMENTE

| Kategorie | Kennzeichnung des Dokuments mit Angabe. soweit erforderlich. der maßgeblichen Teile | Betrifft Anspruch | KLASSIFIKATION DER ANMELDUNG (Int Cl 4) |
|---|---|---|---|
| X | WO-A-8 203 945 (NRC CORP.) <br> * Ansprüche 1-3; Figuren 6,12 * | 1,6 | H 01 L 21/28 <br> H 01 L 21/00 <br> H 01 L 21/74 <br> H 01 L 21/76 <br> H 01 L 21/82 |
| Y | | 8 | |
| | --- | | |
| A | EP-A-0 083 783 (INTERNATIONAL BUSINESS MACHINES CORP.) <br> * Ansprüche 1-15; Figur 3 * | 1,2,4, 6 | |
| | --- | | |
| A | EP-A-0 054 259 (TOKYO SHIBAURA DENKI K.K.) <br> * Ansprüche 1-14; Figuren 1A-1E * | 1,2,6, 7 | |
| | --- | | |
| A | EP-A-0 066 280 (TOKYO SHIBAURA DENKI K.K.) <br> * Ansprüche 1-11; Figuren 1C-1E * | 1,4 | |
| | | | RECHERCHIERTE SACHGEBIETE (Int Cl 4) |
| Y | US-A-4 209 797 (H. EGAWA et al.) <br> * Zusammenfassung * | 8 | H 01 L |
| | --- | | |
| A | GB-A-2 106 713 (ROCKWELL INTERNATIONAL CORP.) | | |
| | ---     -/- | | |

Der vorliegende Recherchenbericht wurde für alle Patentansprüche erstellt

| Recherchenort <br> DEN HAAG | Abschlußdatum der Recherche <br> 14-01-1986 | Prüfer <br> ZOLLFRANK G.O. |
|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | IEEE TRANSACTIONS ON ELECTRON DEVICES, Band ED-29, Nr, 4, April 1982, Seiten 590-596, IEEE, New York, US; P.J. TSANG et al.: "Fabrication of high-performance LDDFET's with oxide sidewall-spacer technology"<br><br>--- | | |
| D,A | IBM TECHNICAL DISCLOSURE BULLETIN, Band 24, Nr. 6, November 1981, Seiten 2863-2866, New York, US; S. DASH et al.: "Method to fabricate polysilicon or polycide buried contacts to diffused lines in a MOSFET"<br><br>----- | | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 14-01-1986 | ZOLLFRANK G.O. |